Europäisches Patentamt

European Patent Office

Office européen des brevets

(11) Publication number: **0 219 812**
A2

(12) **EUROPEAN PATENT APPLICATION**

(21) Application number: **86114311.3**

(22) Date of filing: **16.10.86**

(51) Int. Cl.⁴: **H 01 L 23/48**
**H 01 L 21/48**

(30) Priority: **25.10.85 US 791570**

(43) Date of publication of application:
**29.04.87 Bulletin 87/18**

(84) Designated Contracting States:
**AT BE CH DE ES FR GB GR IT LI LU NL SE**

(71) Applicant: Analog Devices, Inc.
Route 1, Industrial Park P.O. Box 280
Norwood Massachusetts 02062(US)

(72) Inventor: Lyndon, William C.
44 Bramblewood Lane
Braintree Massachusetts 02184(US)

(72) Inventor: Roberts, Carl M.
6 Orchard Lane
Topsfield Massachusetts 01983(US)

(74) Representative: Görtz, Dr. Fuchs, Dr. Luderschmidt
Patentanwälte
Sonnenberger Strasse 100 Postfach 26 26
D-6200 Wiesbaden(DE)

(54) Packaged semiconductor device having solderable external leads and process for its production.

(57) Solderable external lead finishes of packaged semiconductor devices are rendered resistant to solderability failure following burn-in processing by providing a copper plating on the base metal of the external leads and/or by providing an outer solder layer on the external leads by dipping the external leads in a low temperature, dynamic solder bath having a substantially uniform temperature throughout the bath or by employing both features.

FIG. 2

EP 0 219 812 A2

C219812

## BURN-IN RESISTANT SOLDERABLE LEAD FINISH

### FIELD OF THE INVENTION

This invention relates to processes for rendering the solderable external leads of packaged microcomponent semiconductor devices resistant to solderability failure following burn-in processing of such packaged devices. The invention also relates to improved packaged semiconductor chip devices that when solder dipped, the external leads thereof are resistant to solderability failure following burn-in processing of the packaged devices.

### BACKGROUND OF THE INVENTION

The modern assembly processes for microcomponent semiconductor devices are largely automated to increase productivity by reducing costs and increasing assembly rates. In such automated processes, semiconductor integrated circuit chips containing a plurality of electrical elements, such as transistors, diodes, resistors and the like, are formed on silicon wafer substrates and cut into individual chips for mounting onto package support substrates, for example, leaded packages, such as header, cerdip or sidebraze packages.

The chip is mounted onto the leaded package, and electrical elements on the chip are connected by thin electrical conductors from pads on the chip to individual external leads on the leaded packages. One purpose of the external leads is to permit external electrical circuit connections to be made to the various electrical elements or circuits of the chip. A second purpose for the individual external leads on the lead carrying package is for the end user to make a solderable connection into their product or system. The individual external leads on the lead carrying package, after normal assembly processing of chip mounting, wire bonding, and package sealing, are finished with a suitable leadfinish or leadcoating that will ultimately allow the end user to reliably and routinely solder the packaged device into their system.

The suitable leadfinish put on package leads typically is a tin plated coating or solder dipped coating. For many end use requirements, finished lead coated circuit elements are required to be processed through burn-in at 125°C for 168 hours and the leads must pass solderability requirements as set forth in MIL-STD-883. Tin plate has generally proven, over many years, not to be entirely satisfactory to the military products using community as such coated leads unpredictably, and to too high a percentage, fail solderability requirements after burn-in processing. The solderability problem existed to the extent that the MIL-STD-883 specifications were changed to require that tin plated leads be additionally processed and fused after plating and either before or after burn-in. A fused leadfinish is considered more solderable than tin or tin/lead plated leads.

Fusing of tin plate is accomplished in a variety of manufacturing techniques by raising the plated tin above its liquidus temperature. Such manufacturing techniques include processing tin plated leads through a furnace at an adequate temperature; submerging the tin plated leads into a liquid or vapor at an adequate temperature; or by dipping the package leads into a solder pot at 260°C and solder dipping over the tin plated coating resulting in solder dipped leads. The solder dipped coating is a fused leadfinish.

As much as tin plated leads may be fused by the process of solder dipping, leads may also be originally solder coated, and therefore have a fused coating, as a primary or first time leadcoating without tin plating having been originally applied to the leads. This is done by dipping the package leads into a solder pot, typically at a temperature of 260°C.

Although such finished circuit elements may pass the appropriate electrical requirements after burn-in processing, it is known that in many cases the otherwise finished circuit devices are rendered unacceptable or are considered unusable for many end uses because of solderability failure of the external leads following such burn-in processing. Tin plate fusing processes or solder dipping processes employed to date have been generally unable to put any type of lead finish on the device's external leads prior to burn-in such that the device will be adequately resistant to solderability failure following burn-in. Therefore, such failed devices must either be discarded or, in the case of tin plate, be fused after burn-in or, in the case of original solder dip leadfinish, be cleaned and then redipped in solder following the burn-in processing. Neither course is desirable as the first option substantially lowers processing yields, and the second two options of post burn-in tin plate fusing and solder dip reworking adds costs, time and extra steps to the processing of the packaged device product.

It is therefore highly desirable that a packaged device be provided that, when solder dipped prior to burn-in processing of the device, remains solderable following burn-in processing. Also desirable would be a process of solder dipping the external leads of packaged semiconductor chip devices such that the finished circuit devices would be resistant to solderability failure following burn-in processing. Packaged lead frame devices having external leads that could be solder dipped using conventional 260°C solder dipping and yet would not fail solderability requirements following burn-in processing of the packaged devices would also be beneficial. Even more beneficial would be an improved packaged lead frame device having external leads which are resistant to solderability failure following burn-in and are rendered even more resistant to such solderability failure, following burn-in processing, by an improved process of solder dipping said improved package device. The process of solder dipping prior to burn-in would be much more attractive to additional or rework processing after burn-in, and is incrementally more attractive than tin plating and fusing by solder dipping prior to burn-in, as the process would be a single step of manufacturing.

- 5 -

0219812

## SUMMARY OF THE INVENTION

In a process for assembly and production of packaged microcomponent semiconductor devices, devices having solderable external leads resistant to solderability failure following burn-in processing of such devices can be obtained by providing a solder layer on the external leads by dipping the leads in a dynamic solder bath maintained at a substantially uniform, low temperature, which uniform temperature may be a temperature between about 200°C to about 240°C. In materials for assembly and production of said packaged devices, which are to be resistant to solderability failure following burn-in processing thereof, this invention provides novel packaged devices having a copper plate barrier layer placed on the base metal of the external leads before a nickel plate layer and a solder layer are placed on the external leads. In a still further aspect of this invention the improved copper plate barrier layer-containing packaged devices have the solder layer provided thereon by dipping the external leads in a dynamic solder bath maintained at a substantially uniform, low temperature, which uniform temperature may be a temperature between about 200°C to about 240°C, preferably 205°C to 230°C.

## BRIEF DESCRIPTION OF THE DRAWINGS

For the purpose of illustrating the invention, there is shown in the drawings a form which is presently preferred. It should be understood, however, that this invention is not limited to the precise arrangement shown. Moreover, it will be appreciated that Figures 3 to 6 are not drawn to scale but are set forth in the manner shown to indicate the relative relationship and placement of layers.

FIG. 1 is a perspective view, shown considerably enlarged, of a type of packaged microcomponent semiconductor device known in the art and on which the present invention is employed.

FIG. 2 is a greatly enlarged idealized cross-sectional and partial perspective view taken along line 2-2 of Fig. 1 showing one of the external leads of the device of Fig. 1 before solder dip and burn-in processing.

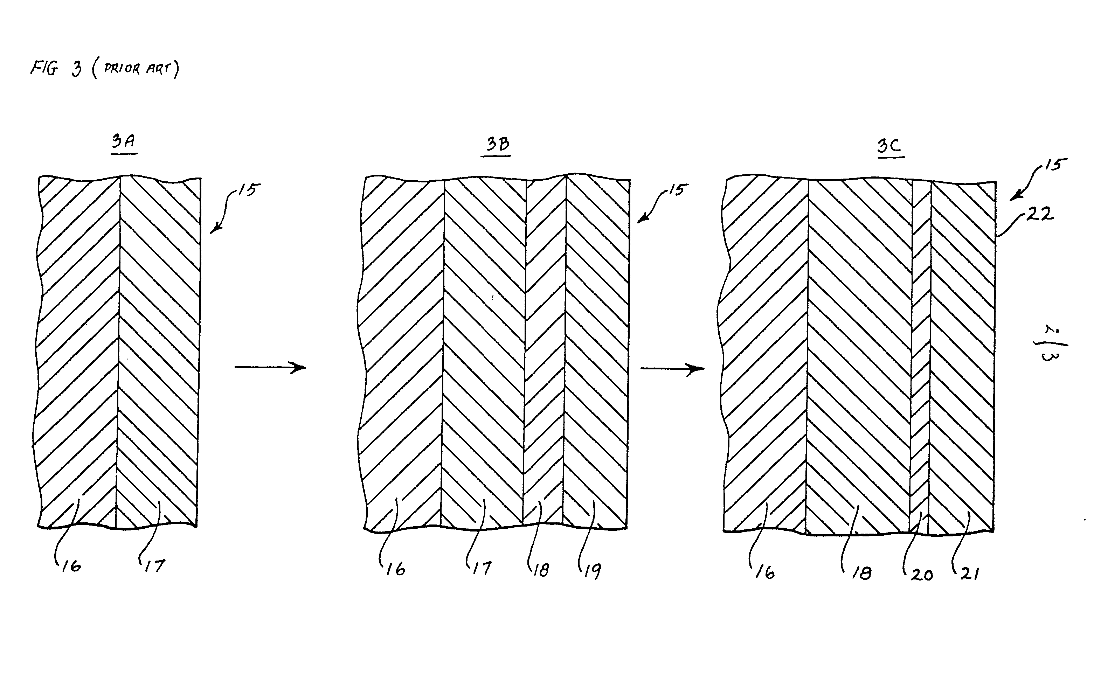

FIG. 3 includes a sequence of views of a further enlargement of a portion of the cross-sectional view in Fig. 2, these views (Figs. 3A, 3B and 3C) being taken generally in the region between the two lines X - X and X'- X' in Fig. 2, (both lines being in the same vertical plane) and showing an idealized vertical cross-section of a portion of the underlying central region and the outer surrounding layers deposited thereon of a prior art external lead, for example such as shown in Fig. 2: before solder dipping (Fig. 3A), following heretofore conventional solder dipping at 260°C (Fig. 3B), and following burn-in processing (Fig. 3C).

FIG. 4 is an enlarged partial cross-sectional view taken generally between lines X - X and X'- X' of Fig. 2 showing an idealized vertical cross-section of a portion of the underlying central region and the outer surrounding layers deposited thereon of an external lead of a device, for example
such as shown in Fig. 2, following burn-in processing after
solder dipping in a dynamic, uniform temperature solder bath at
200°C. according to this invention.

FIG. 5 is another enlarged partial cross-sectional
view generally similar to Fig. 4, except showing an idealized
vertical cross-section of a portion of the underlying central
region and the outer surrounding layers deposited thereon of an
external lead of an improved packaged device embodying this
invention.

FIG. 6 is another enlarged partial cross-sectional
view showing an idealized vertical cross-section of a portion
of the underlying central region and the outer surrounding
layers deposited thereon of an external lead of the device
shown in Fig. 5 following solder dipping and burn-in processing
thereof.

## DETAILS OF THE INVENTION

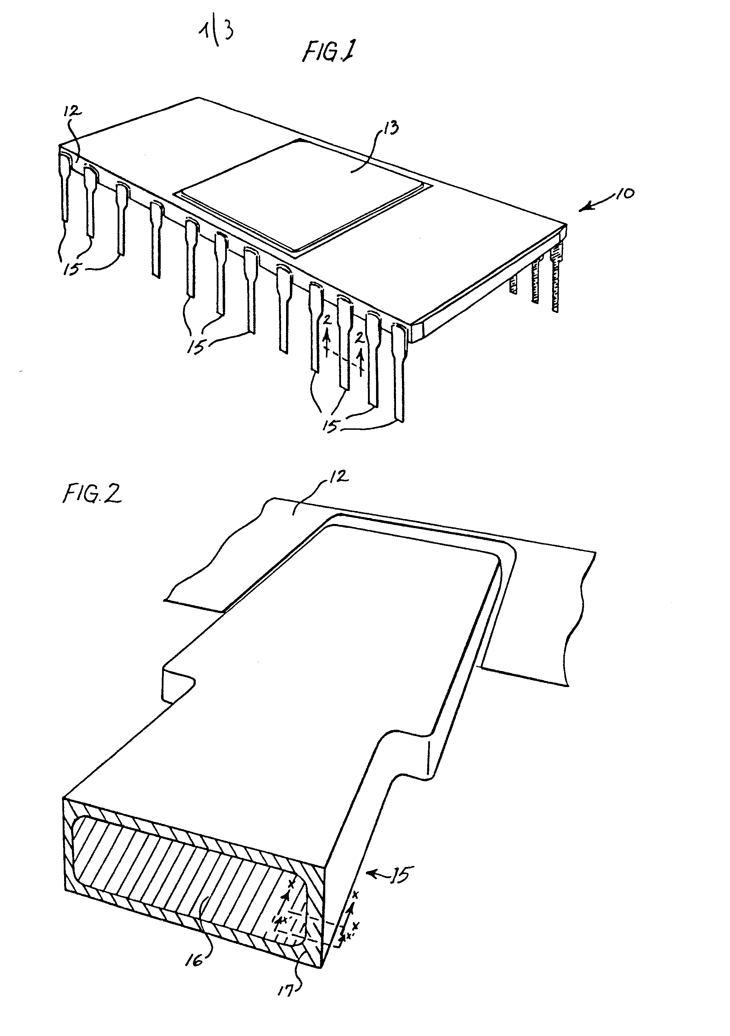

Referring now to the drawings, wherein like numerals
indicate corresponding elements throughout the various FIGURES,
there is shown in Fig. 1 a packaged assembly of a
microcomponent semiconductor chip device 10 for use in various
semiconductor applications. The packaged device 10 comprises
an internally mounted semiconductor integrated circuit chip
(not shown) having internal electrical conductors (also not
shown) from the chip circuits to external leads 15 extending off from an external lateral support member 12 of the package
device 10.  The circuit chip is internally mounted in the
packaged device and hermetically sealed with a lid member 13,
generally a gold layer covering.  For purposes of illustration
only, the type package device exemplified in Fig. 1 is a
sidebraze package.  However, it will be appreciated that such
packaged devices with external leads may be any suitable
package device used in the semiconductor industry, for example,
such as headers, sidebrazes and the like.  The purpose of
external leads 15 on such packaged devices is to permit
external electrical circuit connections to be made to the
integrated circuit chips or to the various electrical elements
found on such chips.

Referring now to Fig. 2 there is shown an idealized
cross-section of the basic construction of a representative one
of the external leads 15 of a packaged device 10 heretofore
typically employed in the industry.  The primary base of the
external lead is a central base metal layer 16, which may be,
for example, either Alloy 42 (42% nickel, 58% iron by weight)
or Kovar alloy (trademark of Westinghouse Electric Corp., a 29%
nickel, 54% iron, 17% cobalt alloy by weight).  The base metal
layer 16 is plated with a covering layer 17 of nickel of a
thickness of from about 2.5 to about 5.25 microns to provide a
suitable base for acceptance of a solder layer during
subsequent processing.

It will be appreciated that with regard to Fig. 2 and
the enlarged cross-sectional views based thereon, namely Figs.
3 to 6, that Fig. 2 only shows the central base metal layer 16 and one additional metal layer 17 deposited thereon, whereas multiple metal layers may be deposited thereon as is apparent from Figs. 3 to 6.

Referring now to Fig. 3, the solderability failure problem of the prior art is illustrated. After the packaged device 10 is assembled and sealed, as shown in Fig. 1, the nickel-plated external leads 15, as shown in Fig. 3A, are then dipped in a static solder bath at 260°C. As shown in Fig. 3B, an outer layer 19 of solder, of a composition generally of 63% tin and 37% lead by weight, is thereby applied to the nickel plate 17 of external leads 15. As the external leads 15 of the device 10 are withdrawn from the solder bath and the solder on the nickel plate layer 17 cools, an intermetallic layer 18 of $Ni_3Sn_4$ forms between the solder layer 19 and the nickel plate 17 as shown in Fig. 3B.

As earlier stated, such finished devices are in many cases required to be processed through burn-in at 125°C for a period of 168 hours. It is known that when such a finished device is subject to such burn-in processing, the resulting processed device often becomes unsolderable or resistant to solderability following the burn-in process. It has been observed that when the finished packaged device is subjected to such burn-in processing, the intermetallic layer 18 grows, at least in part due to the presence of iron in the base metal layer 15 and the elevated temperature of 125°C to which the device 10 is subjected during the burn-in. This elevated temperature accelerates the diffusion between tin and nickel resulting in the growth of the intermetallic layer 18 as shown in Fig. 3C. At the same time, there is a growth of generally segregated tin-rich and lead-rich areas or layers, illustrated at 20 and 21 respectively, in the solder layer. Another factor leading to this diffusion/migration or separation is the electrical current flowing through the device 10 during burn-in. The current flow accelerates diffusion by at least two mechanisms. Increased electron migration between the device and the burn-in socket is one mechanism. Another mechanism is the increased localized temperature increase of the lead caused by heat dissipating from the device inside the package and transfer of this dissipated heat to the external leads, which can cause an additional local temperature increase in some devices of up to an additional 25°C.

The overall effect of this increased diffusion/ migration or separation is shown in Fig. 3C and results in the formation of a lead-rich outer layer 21 leading to the formation of a lead oxide layer 22 on the outer surface of the external lead 15 when the lead on the lead rich surface 21 oxidizes. This lead oxide surface 22 is unsolderable, and the packaged device 10 fails solderability testing. Heretofore, it was necessary to reprocess such burn-in processed devices by stripping the lead oxide layer 22 and lead-rich layer 21 from the external leads 15 and redipping the external leads in solder in an attempt to salvage an otherwise potentially usable device that would, as reprocessed, pass the requisite solderability requirements for military applications.

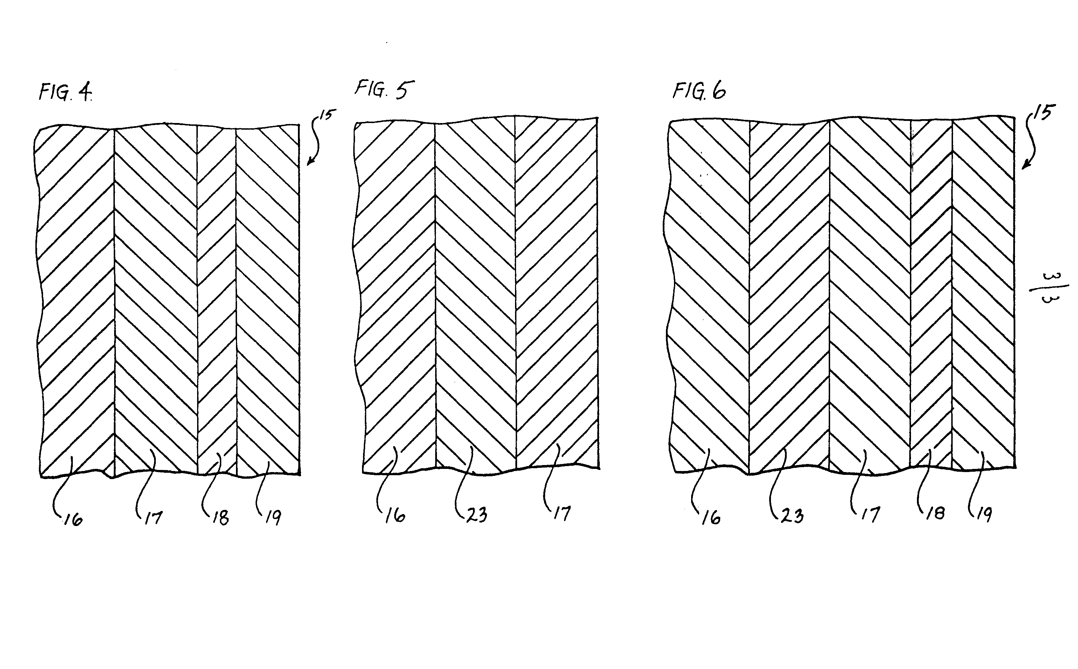

According to this invention solderability failure following burn-in processing of packaged microcomponent semiconductor devices can be cured or alleviated by providing a solder layer on the nickel plate layer 17 of the external
leads 15 of the heretofore used package devices 10 by dipping
the external leads in a dynamic solder bath maintained at a
substantially uniform temperature of between about 200°C and
about 240°C.  When a solder layer is applied in this manner and
the packaged device is subjected to burn-in processing, the
device does not become unsolderable following burn-in.
Instead, the device remains solderable, and the surface and
underlying region of the external leads 15 of such device have
an idealized cross-section, as shown in Fig. 4.  The
intermetallic $Ni_3Sn_4$ layer 18 remains relatively small
during the burn-in process, and formation of any substantial
lead-rich solder layer having an outer surface layer of lead
oxide thereon is prevented or avoided.

The possibility of solderability failure following
burn-in processing can be even further reduced or alleviated by
providing a novel packaged device 10, having external leads 15
with an intermediate copper plate barrier layer 23 between the
base metal layer 16 and the nickel plate layer 17, as shown in
Fig. 5.  The copper plate barrier layer 23 is a barrier layer
of copper of a thickness of from about 2.5 to about 5.25
microns and is applied to the base metal layer 16 of the
external leads 15, by any suitable copper plating technique,
before application of the nickel plate 17.  Such copper plating
techniques are generally known, for example, as disclosed in
the McGraw-Hill Encyclopedia of Science and Technology, Vol. 4,
page 603 (1977).  The packaged devices having a copper plate
barrier layer 23 in the external leads 15 of the device, as
shown in Fig. 5, may then be solder dipped to provide an outer
solder layer 19 on the nickel plate layer 17.  When such copper plate-containing packaged device is then subject to burn-in processing, as previously described, the device is resistant to solderability failure following burn-in, and the surface and underlying region of the external lead 15 has the idealized cross-section as shown in Fig. 6.

While the solder layer 19 on the novel package device with the copper plate barrier layer 23 placed between the base metal layer 16 and nickel plate layer 17 may be deposited on the nickel plate layer by dipping in a static solder bath at 260°C, it is more preferred to apply such a solder layer 19 by dipping the external leads of novel copper plate barrier layer-containing device in a dynamic solder bath maintained at a substantially uniform temperature of between about 200°C and about 240°C, as previously described herein, since such a finished product is even more resistant to solderability failure following burn-in processing than a similar novel packaged device in which the solder is applied by dipping in a static solder bath at 260°C.

When application of a solder layer is accomplished in a dynamic solder bath, it is preferred that a solder wave machine, such as for example an Electrovert SM 10 model wavesolder machine, be employed. Most preferably the temperature of the molten solder in the bath is maintained at as low a temperature as possible while still permitting acceptable deposition of a solder layer on the device leads. Preferably the temperature of the molten solder in the solder bath is maintained at a substantially uniform temperature of about 200°C.

It is an important feature of this invention that when the deposition of the solder layer is accomplished by a low temperature solder bath process, that the temperature within the bath be maintained substantially uniform throughout the whole bath so that there are no localized areas of cooling of the solder, for example, in the immediate area of the leads 15 when a device is dipped in the solder bath. A dynamic solder bath, that is, a solder bath in which a force causes motion of the solder in the bath, produces the desired substantially uniform solder bath temperature. For this reason, a dynamic solder bath such as the mentioned Electrovert SM 10 unit is ideally suited for use although it will be appreciated that any solder bath capable of maintaining a substantially uniform temperature of the solder throughout the solder bath will be suitable. Generally the deposition of an acceptable solder layer on the external leads is accomplished by dipping the external leads in a dynamic solder bath for a period of at about 6 seconds or more with the minimum time being dependent for the most part on the particular device package leads being soldered. The external leads are dipped in the solder bath until there is a melding of the metals and a substantially uniform and acceptable solder layer is deposited as an outer layer on the nickel plate layer of the external leads.

It is believed that the many advantages of this invention will now be apparent to those skilled in the art. It will also be apparent that a number of variations and modifications may be made in this invention without departing from its spirit and scope. Accordingly, the foregoing description is to be construed as illustrative only, rather than limiting.

0219812

# C L A I M S

1. A packaged microcomponent semiconductor device having solderable external leads in which the external leads comprise a central base metal layer, an intermediate copper plate barrier layer plated on said base metal and an outer nickel plate layer.

2. The packaged device of Claim 1 in which the thickness of the copper plate barrier layer is from about 2.5 to about 5.25 microns.

3. The packaged device of Claim 2 comprising a solderable solder layer on the outside surface of the nickel plate layer.

4. The packaged device of Claim 3 wherein the solder layer has been applied by dipping the external leads of said device in a dynamic solder bath maintained at a substantially uniform temperature of from about 200°C to about 240°C.

5. The packaged device of Claim 4 wherein the solder layer is applied by dipping in a dynamic wavesolder bath maintained at a substantially uniform temperature of about 200°C.

6. A process for rendering the external leads of a packaged microcomponent semiconductor device resistant to solderability failure following burn-in processing of said device comprising applying a layer of solder to said external leads prior to burn-in processing by dipping the external leads of said packaged device in a dynamic solder bath maintained at a substantially uniform temperature of from about 200°C to about 240°C.

7. The process of Claim 6 wherein the external leads of the packaged device are dipped in the bath of a wavesolder machine maintained at a substantially uniform temperature of about 200°C.

8. The process of Claim 7 wherein the external leads of said packaged device comprise a central base metal layer, an  intermediate copper plate barrier layer and an outer nickel plate layer.

9. The process of Claim 8 wherein the copper plate barrier layer has a thickness of from about 2.5 to about 5.25 microns.

10. A process for rendering the external leads of a packaged microcomponent semiconductor device resistant to solderability failure following burn-in processing of said device and in which the external leads thereof comprise a
central base metal layer and an outer nickel plate layer,
comprising plating the central base metal layer of said
external leads with an intermediate copper plate barrier layer
and thereafter applying the outer nickel plate layer to the
copper plate barrier layer containing external leads followed
by dipping said nickel plated external leads in a solder bath
to provide an outermost solder layer.

11.  The process of Claim 10 wherein the copper plate
barrier layer is plated on the central base metal layer to a
thickness of from about 2.5 to about 5.25 microns.

12.  The process of Claim 12 wherein the nickel plated
external leads are dipped in a dynamic solder bath maintained
at a substantially uniform temperature of from about 200°C to
about 240°C.

13.  The process of Claim 13 wherein the nickel plated
external leads are dipped in a dynamic wavesolder bath
maintained at a substantially uniform temperature of about
200°C.

1|3

0219312

FIG.1

FIG.2

FIG 3 (PRIOR ART)

3A

3B

3C

15

22

2/3

0219812

FIG. 4.

FIG. 5

FIG. 6

3/3

0219812